# EUROPEAN PATENT APPLICATION

(11) **EP 3 291 285 A1**
(43) Date of publication of application: **07.03.2018**
(21) Application number: 17172245.7
(22) Date of filing: 22.05.2017
(51) Int. Cl.: H01L 21/60, H01L 21/56, H01L 23/498

(54) **SEMICONDUCTOR PACKAGE STRUCTURE WITH A POLYMER GEL SURROUNDING SOLDERS CONNECTING A CHIP TO A SUBSTRATE AND MANUFACTURING METHOD THEREOF**

(30) Priority: 31.08.2016 TW 105128012
(71) Applicant: Kinpo Electronics, Inc., New Taipei City 22201 (TW)
(72) Inventor: CHENG, Yu-Wei, New Taipei City 22201 (TW)
(74) Representative: Haseltine Lake LLP

(57) **Abstract**

A manufacturing method of a package structure (100) such as a semiconductor package structure comprises: providing a substrate (110) such as a flexible printed circuit (FPC) board, wherein the substrate (110) comprises a plurality of solder pads (112); forming a patterned solder resist layer (120) on the substrate (110), wherein the patterned solder resist layer (120) comprises a plurality of stepped openings (122) exposing the solder pads (112) respectively; disposing a polymer gel (130) on a top surface of the patterned solder resist layer (120), wherein the polymer gel (130) at least surrounds a disposing region of the solder pads (112) and is disposed between adjacent two of the solder pads (112); disposing a plurality of solders (140) on the solder pads (112) respectively, wherein the solders (140) are located in the stepped openings (122) respectively; disposing a chip (150) on the substrate (110), wherein the chip (150) comprises an active surface (152) and a plurality of bond pads (154) located on the active surface (152) and the bond pads (154) are connected to the solder pads (112) through the solders (140); and performing a reflow process on the solders (140), such that the solders (140) completely fill the stepped openings (122) of the patterned solder resist layer (120) and the polymer gel (130) is filled between a top surface of the patterned solder resist layer (120) and the active surface (152) and fills between two adjacent solders (140).

## Description

### BACKGROUND OF THE INVENTION

### Field of the Invention

The present invention generally relates to a semiconductor structure and a manufacturing method thereof. More particularly, the present invention relates to a semiconductor package structure and a manufacturing method thereof.

### Description of Related Art

As technology advances, all kinds of electronic devices are developed towards miniaturization and multiple functions. Hence, in order for chips in electronic device to be able to transmit or receive more signals, contacts electrically connected between chips and circuit boards are also developed towards high density. In the prior art, a chip and a substrate are electrically connected mostly by disposing an anisotropic conductive film (ACF) between contacts of the chip and conductive structures of the substrate. The contacts of the chip and the conductive structures of the substrate both face the ACF. Afterwards, the contact of the chip, the ACF and the conductive structure of the substrate are laminated so that each of the contacts of the chip is electrically connected to each conductive structure of the substrate through conductive particles in the ACF.

In addition, in the manufacturing process of such package, a thermal lamination process need to be firstly performed on an ACF to attach the ACF to a bonding region of the substrate, and the chip is then laminated on the ACF under a high temperature, such that the contacts of the chip are electrically connected to the conductive structures of the substrate through conductive particles in the ACF. The above-mentioned two steps need to be performed separately. As such, the complexity of the manufacturing process increases and the applicable field is limited, so as to increase the process time, which leads to decrease of productivity. Moreover, an impedance of the ACF may become unstable after the ACF being pressed repeatedly and/or the environment thereof changes, which leads to decrease of electrical performance of the package structure. Furthermore, the ACF is expensive, so using the ACF also increases production cost.

### SUMMARY OF THE INVENTION

Accordingly, the present invention is directed to a package structure and a manufacturing method thereof, which simplify the manufacturing process and improve electrical performance of the package structure.

The present invention provides a manufacturing method of a package structure, and the manufacturing method includes the following steps. A substrate is provided, wherein the substrate includes a plurality of solder pads. A patterned solder resist layer is formed on the substrate, wherein the patterned solder resist layer includes a plurality of stepped openings exposing the solder pads respectively. A polymer gel is disposed on a top surface of the patterned solder resist layer, wherein the polymer gel at least surrounds a disposing region of the solder pads and disposed between adjacent two of the solder pads. A plurality of solders are disposed on the solder pads respectively, wherein the solders are located in the stepped openings respectively. A chip is disposed on the substrate, wherein the chip includes an active surface and a plurality of bond pads located on the active surface and the bond pads are connected to the solder pads through the solders. A reflow process is performed on the solders, such that the polymer gel is filled between a top surface of the patterned solder resist layer and the active surface.

The present invention further provides a package structure, and the package structure includes a substrate, a patterned solder resist layer, a plurality of solders, a chip and a polymer gel. The substrate includes a plurality of solder pads. The patterned solder resist layer is disposed on the substrate and includes a plurality of stepped openings. The stepped openings expose the solder pads respectively. The solders are disposed on the solder pads and located in the stepped openings respectively. The chip is disposed on the substrate and includes an active surface and a plurality of bond pads. The bond pads are disposed on the active surface and connected to the solder pads by the solders. The polymer gel fills between a top surface of the patterned solder resist layer and the active surface. The polymer gel at least surrounds a disposing region of the solders and fills between two adjacent solders.

Based on the above-mentioned description, in the disclosure, the polymer gel is disposed on the top surface of the patterned solder resist layer having the stepped openings, wherein the stepped openings expose the solder pads of the substrate respectively. Moreover, the polymer gel surrounds the disposing region of the solder pads and is disposed between adjacent two of the solder pads. Then, the chip is disposed on the substrate through the solders. Accordingly, the solders would shrink after being reflowed and cured, so as to compress the polymer gel, so that the polymer gel can completely fill the gap between the top surface of the patterned solder resist layer and the active surface of the chip to achieve a sealing effect and prevent moisture from external environment to permeate into the package structure. Therefore, in the disclosure, a sealing structure for the package structure can be simultaneously formed by one mounting process, such that the conventional ACF process can be replaced, so as to simplify the manufacturing process of the package structure and reduce the production cost. Moreover, since the chip is disposed on the substrate by surface-mount technology, an impedance thereof is more stable, compared to ACF. Therefore, the disclosure may also enhance electrical performance of the package structure.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.
Fig. 1A to Fig. 1K illustrate cross-sectional views of a manufacturing process of a package structure according to an exemplary embodiment.
Fig. 2 illustrates a top view of a layout of a polymer gel on a patterned solder resist layer according to an exemplary embodiment.
Fig. 3 illustrate a top view of a layout of a polymer gel on a patterned solder resist layer according to another exemplary embodiment.

### DESCRIPTION OF THE EMBODIMENTS

The present invention will now be described more fully with reference to the accompanying drawings, in which exemplary embodiments of the invention are shown. The terms used herein such as "above", "below", "front", "back", "left" and "right" are for the purpose of describing directions in the figures only and are not intended to be limiting of the invention. Moreover, in the following embodiments, the same or similar reference numbers denote the same or like components.

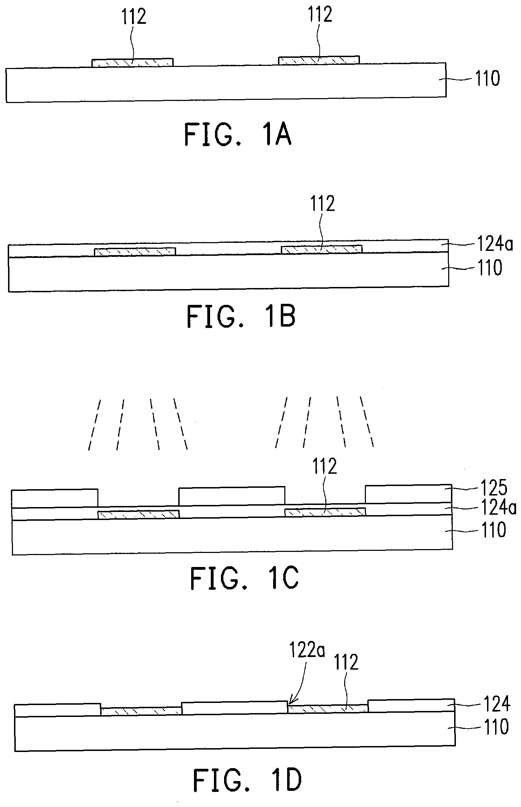

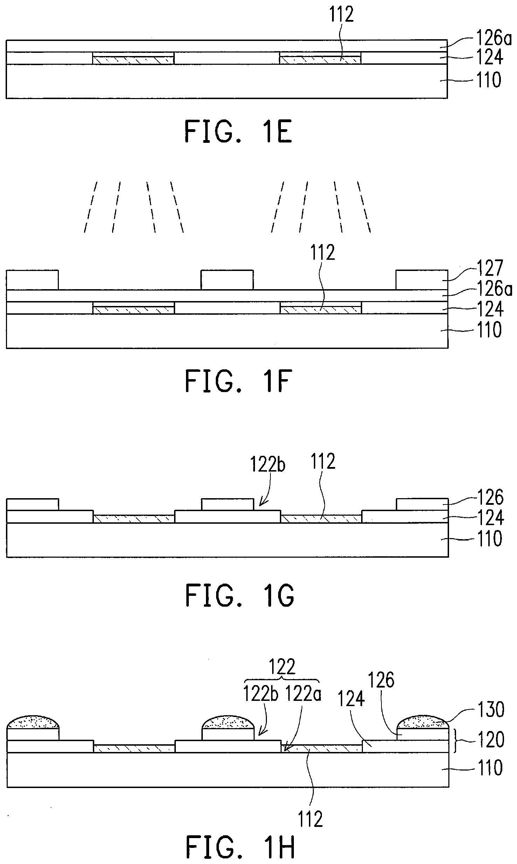

Fig. 1A to Fig. 1K illustrate cross-sectional views of a manufacturing process of a package structure according to an exemplary embodiment. In the present embodiment, a manufacturing method of a package structure may include the following steps. Firstly, a substrate 100 as shown in Fig. 1A is provided, wherein the substrate 110 includes a plurality of solder pads 112. Next, a patterned solder resist layer 120 is formed on the substrate 110 as shown in Fig. 1H, wherein the patterned solder resist layer 120 includes a plurality of stepped openings 122 as shown in Fig. 1H, and the stepped openings 122 expose the solder pads 112 on the substrate 110 respectively. In the present embodiment, the substrate 110 may be a flexible printed circuit (FPC) board. Certainly, the disclosure is not limited thereto. In other embodiments, the substrate 110 may also be a printed circuit board or other suitable substrate.

For example, the step of forming the patterned solder resist layer 120 on the substrate 110 may include the following steps. Firstly, a first solder resist layer 124a is formed on the substrate 110. In the present embodiment, the first solder resist layer 124a may, for example, completely cover a top surface of the substrate 110 and cover the solder pads 112. Next, a first patterning process is performed on the first solder resist layer 124a. The first patterning process may be, for example, a photolithography process. In detail, the first patterning process may include disposing a patterned photoresist layer 125 having a plurality of openings on the first solder resist layer 124a as shown in Fig. 1C, wherein the openings expose a portion of the first solder resist layer 124a. Then, an exposure process and a developing process is performed on the exposed first solder resist layer 124a to remove the exposed first solder resist layer 124a and form the first patterned solder resist layer 124 as shown in Fig. 1D. Herein, the first patterned solder resist layer 124 includes a plurality of first openings 122a, and the first openings 122a expose the solder pads 112 respectively. It is noted that the above-mentioned patterning process is taking a positive acting resist for example. Certainly, in other embodiment, the patterning process may also use negative acting resist and change pattern of the patterned photoresist layer to form the first patterned solder resist layer 124. The disclosure is not limited thereto.

Next, a second solder resist layer 126a as shown in Fig. 1E is formed on the first patterned solder resist layer 124. Then, a second patterning process is performed on the second solder resist layer 126a. The second patterning process may also be a photolithography process. In detail, the second patterning process may include disposing a patterned photoresist layer 127 having a plurality of openings on the second solder resist layer 126a as shown in Fig. IF, wherein the openings expose a portion of the second solder resist layer 126a. Then, an exposure process and a developing process is performed on the exposed second solder resist layer 126a to remove the exposed second solder resist layer 126a and form the second patterned solder resist layer 126 as shown in Fig. 1G. Herein, the second patterned solder resist layer 126 includes a plurality of second openings 122b, and the second openings 122b expose the first openings 122a and a portion of the first patterned solder resist layer 124 surrounding the first openings 122a. Namely, the patterned solder resist layer 120 shown in Fig. 1H may be formed by stacking the first patterned solder resist layer 124 and the second patterned solder resist layer 126, and the first openings 122a of the first patterned solder resist layer 124 and the second openings 122b of the second patterned solder resist layer 126 jointly define the stepped openings. Similarly, the second patterning process may also use negative acting resist and change the pattern of the patterned photoresist layer to form the second patterned solder resist layer 126. The disclosure is not limited thereto.

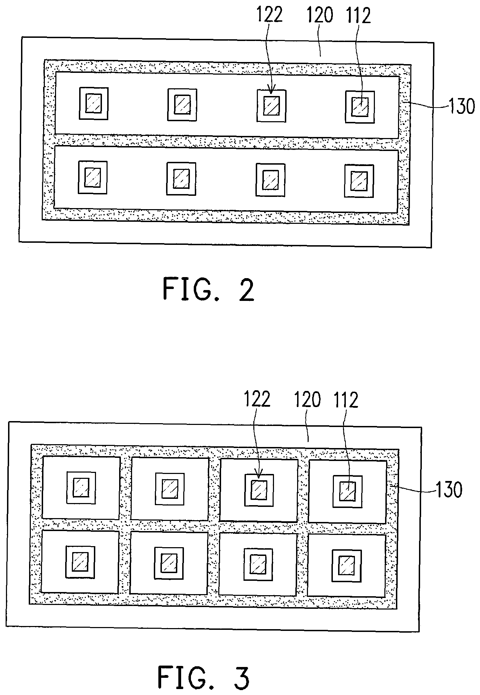

Fig. 2 illustrates a top view of a layout of a polymer gel on a patterned solder resist layer according to an exemplary embodiment. Fig. 3 illustrate a top view of a layout of a polymer gel on a patterned solder resist layer according to another exemplary embodiment. Referring to Fig. 1H and Fig. 2, next, a polymer gel 130 is disposed on a top surface of the patterned solder resist layer 120. In detail, the polymer gel 130 is disposed on an upper surface of the second patterned solder resist layer 126. The polymer gel 130 may be a chemical compound with high molecular weight (usually up to 10 to 106), which is composed of many identical and/or simple structural units repeatedly connected to each other through covalent bonds. In the present embodiment, a material of the polymer gel 130 may include synthetic polyester resin or any other suitable waterproof and insulating materials with high molecular weight. The method of disposing the polymer gel 130 on the patterned solder resist layer 120 includes screen printing. Certainly, the present embodiment is merely for illustration, and the disclosure is not limited thereto. In the present embodiment, the polymer gel 130 may at least surrounds a disposing region of the solder pads 112 and is disposed between adjacent two of the solder pads 112. In other words, the polymer gel 130 may be disposed along a periphery of the solder pads 112 to surround the solder pads 112, and at least disposed between two of the solder pads 112, which are adjacent to each other. For example, the polymer gel 130 surrounds a periphery of the solder pads 112 and crosses between upper row and lower row of the solder pads as shown in Fig. 2. In addition, in another embodiment, the polymer gel 130 may surround each of the stepped openings 122 as shown in Fig. 3, which means surrounding a periphery of each of the solder pads 112.

Next, in one embodiment, a pre-curing process may be performed on the polymer gel 130 to make the polymer gel 130 in a semi-cured state. To be more specific, the pre-curing process may include, for example, performing a heating process on the polymer gel 130, wherein the heating temperature of the heating process substantially ranges from 50°C to 80°C. Certainly, the present embodiment is merely for illustration and the disclosure is not limited thereto.

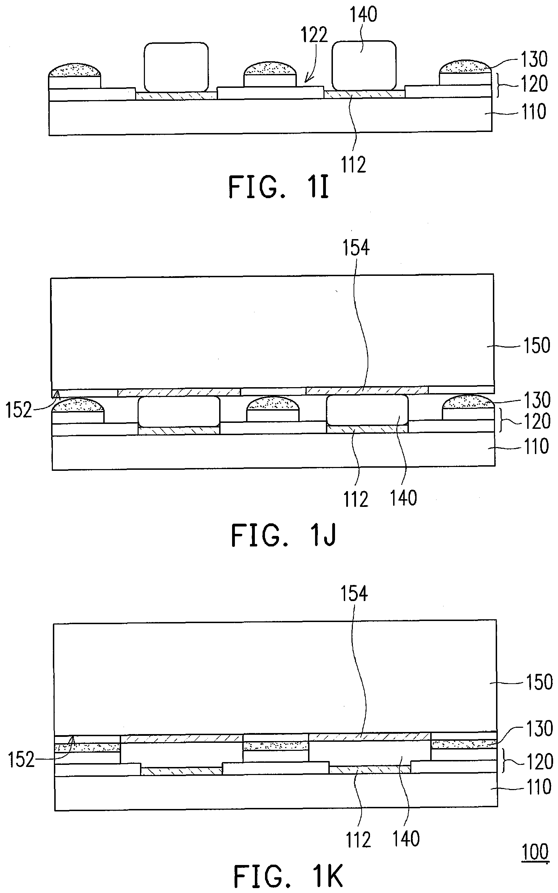

Referring to Fig. 1I, a plurality of solders 140 are disposed on the solder pads 112 respectively, wherein the solders 140 are located in the stepped openings 122 respectively. In the present embodiment, the method of disposing the solders 140 on the solder pads 112 respectively includes screen printing. Certainly, the disclosure is not limited thereto. Next, a chip 150 is disposed on the substrate 110, wherein the chip 150 includes an active surface 152 and a plurality of bond pads 154. The bond pads 154 are located on the active surface 152 and connected to the solder pads 112 through the solders 140. In other words, in the present embodiment, the chip 150 is mounted on the substrate 110 by surface-mount technology (SMT). In the present embodiment, a size of each of the bond pads 154 is substantially larger than a size of each of the solder pads 112 as shown in Fig. 1J. Certainly, the disclosure is not limited thereto. The polymer gel 130 is located between the top surface of the patterned solder resist layer 120 and the active surface 152 of the chip 150.

Next, a reflow process is performed on the solders 140 to fix the chip 150 on the substrate 110. After being reflowed, the solders 140 completely fill the stepped openings 122 of the patterned solder resist layer 120. At the time, the solders 140 would shrink after being reflowed and cured, so as to compress the polymer gel 130, so that the polymer gel 130 completely fill the gap between the top surface of the patterned solder resist layer 120 and the active surface152 to achieve a sealing effect and prevent moisture from external environment to permeate into the package structure 100. As such, the manufacture of the package structure 100 as shown in Fig. 1K is substantially done.

In structure, the package structure 100 formed by the above-mentioned manufacturing method may include a substrate 110, a patterned solder resist layer 120, a plurality of solders 140, a chip 150 and a polymer gel 130. The substrate 110 includes a plurality of solder pads 112. The patterned solder resist layer 120 is disposed on the substrate 110 and includes a plurality of stepped openings 122. The stepped openings 122 expose the solder pads 112 respectively. In detail, the patterned solder resist layer 120 includes the first patterned solder resist layer 124 and the second patterned solder resist layer 122 as shown in Fig. 1H. The first patterned solder resist layer 124 is disposed on the substrate 110 and includes a plurality of first openings 122a, and the first openings 122a expose the solder pads 112 respectively. The second patterned solder resist layer 126 is disposed on the first patterned solder resist layer 124 and includes a plurality of second openings 122b, and the second openings 122b expose the first openings 122a and a portion of the first patterned solder resist layer 124 surrounding the first openings 122a, wherein the first openings 122a and the second openings 122b jointly define the stepped openings 122 of the patterned solder resist layer 120.

Moreover, the solders 140 are disposed on the solder pads 112 and located in the stepped openings 122 respectively. The chip 150 is disposed on the substrate 110 and includes an active surface 152 and a plurality of bond pads 154. The bond pads 154 are disposed on the active surface 152 and connected to the solder pads 112 by the solders 140. The polymer gel 130 fills between a top surface of the patterned solder resist layer 120 and the active surface 152 of the chip 150, wherein the polymer gel 130 at least surrounds a disposing region of the solders 140 and fills between two of the solders 140, which are adjacent to each other.

In sum, in the disclosure, the polymer gel is disposed on the top surface of the patterned solder resist layer having the stepped openings, wherein the stepped openings expose the solder pads of the substrate respectively. Moreover, the polymer gel surrounds the disposing region of the solder pads and is disposed between adjacent two of the solder pads. Then, the chip is disposed on the substrate through the solders. Accordingly, the solders would shrink after being reflowed and cured, so as to compress the polymer gel, so that the polymer gel can completely fill the gap between the top surface of the patterned solder resist layer and the active surface of the chip to achieve a sealing effect and prevent moisture from external environment to permeate into the package structure.

Therefore, in the disclosure, a sealing structure for the package structure can be simultaneously formed by one mounting process, such that the conventional ACF process can be replaced, so as to simplify the manufacturing process of the package structure and reduce the production cost. Moreover, since the chip is disposed on the substrate by surface-mount technology, an impedance thereof is more stable, compared to ACF. Therefore, the disclosure may also enhance electrical performance of the package structure.

## Claims

1. A manufacturing method of a package structure (100), comprising:
providing a substrate (110), wherein the substrate (110) comprises a plurality of solder pads (112);
forming a patterned solder resist layer (120) on the substrate (110), wherein the patterned solder resist layer (120) comprises a plurality of stepped openings (122) exposing the solder pads (112) respectively;
disposing a polymer gel (130) on a top surface of the patterned solder resist layer (120), wherein the polymer gel (130) at least surrounds a disposing region of the solder pads (112) and disposed between adjacent two of the solder pads (112);
disposing a plurality of solders (140) on the solder pads (112) respectively, wherein the solders (140) are located in the stepped openings (122) respectively;
disposing a chip (150) on the substrate (110), wherein the chip (150) comprises an active surface (152) and a plurality of bond pads (154) located on the active surface (152) and the bond pads (154) are connected to the solder pads (112) through the solders (140); and
performing a reflow process on the solders (140), such that the polymer gel (130) is filled between a top surface of the patterned solder resist layer (120) and the active surface (152).

2. The manufacturing method of a package structure (100) as claimed in claim 1, wherein the step of forming the patterned solder resist layer (120) on the substrate (110) comprises:
forming a first solder resist layer (124a) on the substrate (110), wherein the first solder resist layer (124a) covers the solder pads (112);
performing a first patterning process on the first solder resist layer (124a) to form a first patterned solder resist layer (124) comprising a plurality of first openings (122a), wherein the first openings (122a) expose the solder pads (112) respectively;
forming a second solder resist layer (126a) on the first patterned solder resist layer (124); and
performing a second patterning process on the second solder resist layer (124a) to form a second patterned solder resist layer (126) comprising a plurality of second openings (122b), wherein the second openings (122b) expose the first openings (122a) and a portion of the first patterned solder resist layer (124) surrounding the first openings (122a), and each of the first openings (122a) and the corresponding second opening (122b) jointly define each of the stepped openings (122).

3. The manufacturing method of a package structure (100) as claimed in claim 2, wherein the polymer gel (130) is disposed on the second patterned solder resist layer (126).

4. The manufacturing method of a package structure (100) as claimed in claim 2, wherein the polymer gel (130) surrounds each of the stepped openings (122).

5. The manufacturing method of a package structure (100) as claimed in claim 2, wherein a material of the polymer gel (130) comprises synthetic polyester resin.

6. The manufacturing method of a package structure (100) as claimed in claim 1, further comprising:
before disposing the solders (140) on the solder pads (112) respectively, performing a pre-curing process on the polymer gel (130) to make the polymer gel (130) in a semi-cured state.

7. The manufacturing method of a package structure (100) as claimed in claim 6, wherein the pre-curing process comprises performing a heating process on the polymer gel (130).

8. The manufacturing method of a package structure (100) as claimed in claim 7, wherein a heating temperature of the heating process performed on the polymer gel (130) substantially ranges from 50°C to 80°C.

9. A package structure (100), comprises:
a substrate (110) comprising a plurality of solder pads (112);
a patterned solder resist layer (120) disposed on the substrate (110) and comprises a plurality of stepped openings (122) exposing the solder pads (112) respectively;
a plurality of solders (140) disposed on the solder pads (112) and located in the stepped openings (122) respectively;
a chip (150) disposed on the substrate (110) and comprises an active surface (152) and a plurality of bond pads (154), wherein the bond pads (154) are disposed on the active surface (152) and connected to the solder pads (112) by the solders (140); and
a polymer gel (130) filling between a top surface of the patterned solder resist layer (120) and the active surface (152), wherein the polymer gel (130) at least surrounds a disposing region of the solders (140) and fills between adjacent two of the solders (140).

10. The package structure (100) as claimed in claim 9, wherein the patterned solder resist layer (120) comprises:
a first patterned solder resist layer (124) disposed on the substrate (110) and comprising a plurality of first openings (122a) exposing the solder pads (112) respectively; and
a second patterned solder resist layer (126) disposed on the first patterned solder resist layer (124) and comprising a plurality of second openings (122b), wherein the second openings (122b) expose the first openings (122a) and a portion of the first patterned solder resist layer (124) surrounding the first openings (122a), and each of the first openings (122a) and the corresponding second opening (122b) jointly define each of the stepped openings (122).

11. The package structure (100) as claimed in claim 10, wherein the polymer gel (130) fills between the second patterned solder resist layer (126) and the chip (150).

12. The package structure (100) as claimed in claim 9, wherein the polymer gel (130) surrounds each of the stepped openings (122).

13. The package structure (100) as claimed in claim 9, wherein the solders (140) fill the stepped openings (122) respectively.

14. The package structure (100) as claimed in claim 9, wherein a material of the polymer gel (130) comprises synthetic polyester resin.

15. The package structure (100) as claimed in claim 9, wherein the substrate (110) comprises a flexible printed circuit (FPC) board.
